# EUROPEAN PATENT APPLICATION

(11) **EP 2 690 792 A1**
(43) Date of publication of application: **29.01.2014**
(21) Application number: 12178273.4
(22) Date of filing: 27.07.2012
(51) Int. Cl.: H03M 13/27

(54) **Improved cell interleaving for quasi-cyclic LDPC codes**

(71) Applicant: Panasonic Corporation, Osaka 571-8501 (JP)
(72) Inventor: Petrov, Mihail, 63225 Langen (DE)
(74) Representative: Grünecker, Kinkeldey, Stockmair & Schwanhäusser

(57) **Abstract**

The present invention relates to digital communication systems that employ quasi-cyclic low-density parity-check (QC-LDPC) codes. A transmitter comprises a bit interleaver for permuting bits of a QC-LDPC codeword, a constellation mapper for mapping the permuted bits to constellation blocks, and a cell interleaver for permuting the constellation blocks. The bit interleaver can be implemented in a highly efficient manner if the codeword is divided into a plurality of sections such the bit permutation can be performed independently for each section. Moreover, a high degree of time diversity is achieved by implementing the cell interleaver in form of a column-row interleaver wherein the number of rows is equal to the number of bit interleaver sections or to a multiple thereof. The bit deinterleaver and the cell deinterleaver of a corresponding receiver are configured to revert the respective permutations in the transmitter.

## Description

### TECHNICAL FIELD

The present invention relates to the field of digital communications, specifically to communication systems that employ quasi-cyclic low-density parity-check codes.

### BACKGROUND OF THE INVENTION

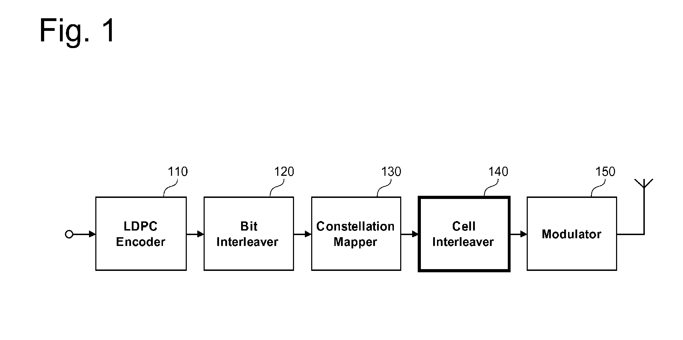

Figure 1 shows the block diagram of a transmitter that employs LDPC codes, the diagram being simplified to include only those blocks which are relevant to the invention.

The transmitter receives at its input binary blocks of a predetermined length, containing the information to be transmitted. Each information block is first encoded by an LDPC (low-density parity-check) encoder 110, the encoding process consisting in computing and adding redundancy bits in order to make the reception of the information block more robust against errors.

The bits of the encoded LDPC codeword, thereafter referred to as LDPC block, are interleaved using a bit interleaver 120. The interleaved LDPC block is the fed to constellation mapper 130 in order to be mapped onto complex symbols or blocks of complex symbols, which are referred to as constellations or constellation blocks, respectively. This mapping will be explained in greater detail herebelow. The complex symbols are also referred to as cells.

The cells produced by the constellation mapper 130 are then interleaved using a cell interleaver 140 and fed to a modulator 150 which generates the signal to be transmitted, e.g. using OFDM (orthogonal frequency-division multiplexing).

LDPC codes are linear error-correcting codes that are fully defined by a parity-check matrix (PCM), which is a binary sparse matrix that represents the connection of the codeword bits (also referred to as variable nodes) to the parity checks (also referred to as check nodes). The columns and the rows of the PCM correspond to the variable and the check nodes respectively. Connections of the variable nodes to the check nodes are represented by "1" entries in the PCM.

Quasi-cyclic (QC) LDPC codes have a structure that makes them particularly suitable for hardware implementation. In fact, most if not all standards today use quasi-cyclic LDPC codes. The PCM of such a code has a special structure consisting of circulant matrices (also referred to as circulants). A circulant is a square matrix in which each row is a cyclic shift of the previous row with one position, and can have one, two, or more cyclically-shifted diagonals. The size of each circulant is QxQ, where Q is referred to as the cyclic factor of the LDPC code. Such a quasi-cyclic structure allows Q check nodes to be processed in parallel, which is clearly advantageous for an efficient hardware implementation.

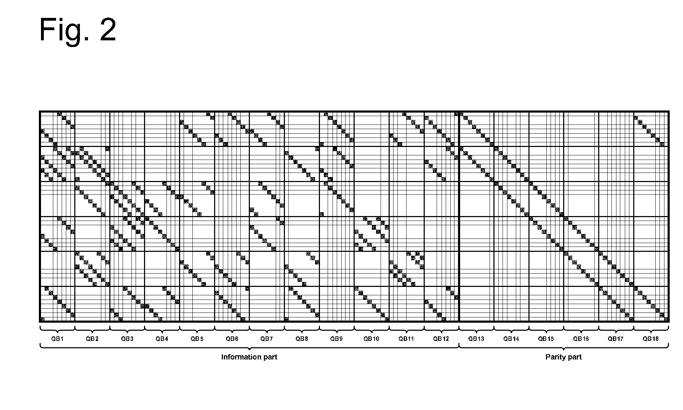

Figure 2 shows the PCM of an example LDPC code with a cyclic factor Q=8, the PCM having circulants with one or two diagonals. This code encodes a block of 8x12=96 bits to a codeword of 8x16=128 bits, having therefore a code rate of 2/3. The codeword bits are subdivided into blocks of Q bits, which will be referred to as cyclic blocks and denoted by QB throughout this document.

The code in Figure 2 belongs to a special family of QC LDPC codes are the repeat-accumulate (RA) QC LDPC codes. These codes are well known for their ease of encoding and are encountered in a large number of standards, such as the second-generation DVB standards: DVB-S2, DVB-T2, and DVB-C2. For these codes the right-hand side of the PCM, which corresponds to the parity bits, has a staircase structure.

A bit interleaver that allows for a particularly efficient hardware implementation due to its high degree of parallelism is constructed by dividing the QC-LDPC codeword into a plurality of sections such that the permutation for mapping the bits of the QC-LDPC codeword to a sequence of constellation words can be performed independently for each of these sections. Specifically, the codeword is divided into N/M sections, wherein N is the number of cyclic blocks within the codeword and M the number of bits per constellation word. Hence, each section comprises M cyclic blocks and each constellation word is associated with a corresponding one of the sections. The bit permutation is adapted such that each constellation word is made up of M bits from M distinct cyclic blocks of the corresponding section.

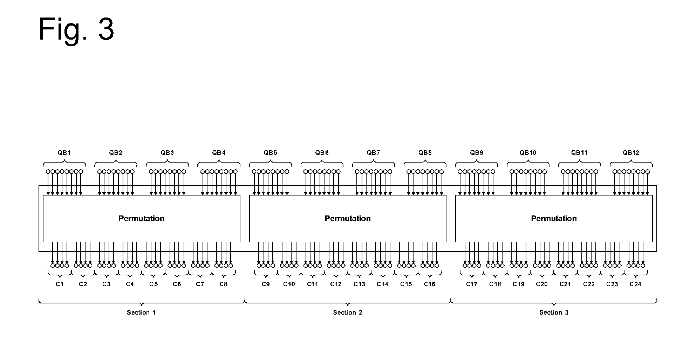

An example of such a bit interleaver that is specifically adapted to the structure of a QC LDPC block is illustrated in Figure 3. The example LDPC code of Figure 3, which has 12 QBs per codeword and 8 bits per QB, will be used here throughout.

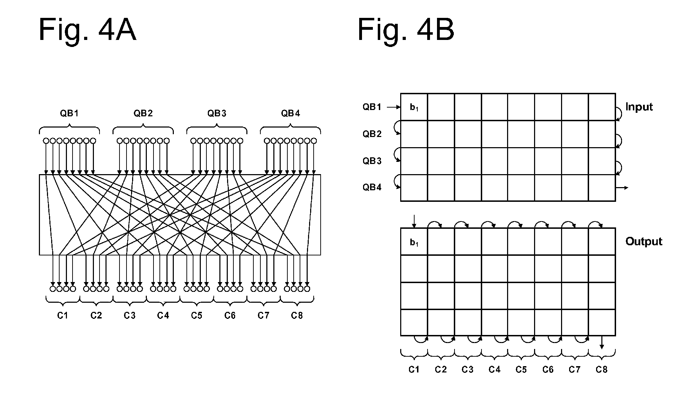

The bit interleaver of Figure 3 is characterized in that the QBs of an LDPC block are grouped into sections, each section being interleaved separately using a section permutation, as shown in Figure 4A. The number of QBs per interleaving section (4 in this example) is a parameter of the interleaver and will be denoted by M here throughout. The section permutation is performed conceptually by writing the Q*M bits of each section row by row into a matrix with M rows and Q columns and reading them out column by column, as illustrated in Fig. 4B. Thus, the output of the section interleaver consists of groups of M bits, the M bits belonging to M different QBs of the original LDPC block.

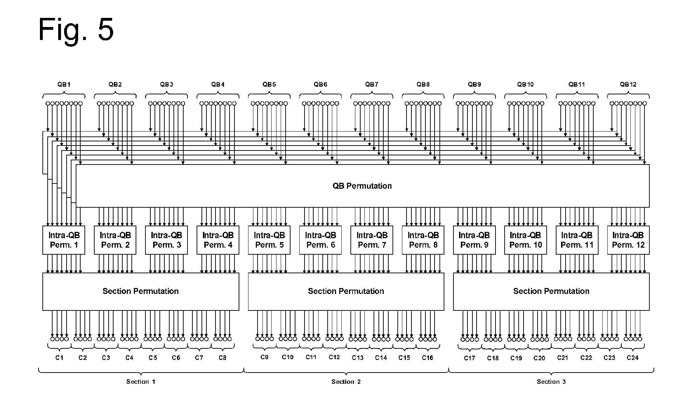

Prior to the grouping of the QBs into sections, the order of the QBs in the LDPC codeword can be changed according to a predefined permutation, referred to as QB permutation. Moreover, additional permutations can be applied to the Q bits of each QBs. These permutations are referred to as intra-QB permutations and are typically cyclic shifts, the shift value being different for each QB. The resulting structure is shown in Figure 5.

While these two kinds of permutations are important for performance optimization, they are not directly relevant to the present invention. In fact, they can be regarded as part of the LDPC code definition. Thus, the QB permutation is equivalent to a permutation of the QB columns in the original PCM, whereas the intra-QB cyclic shifts increment modulo Q the original cyclic shifts of the diagonals in the PCM, the same cyclic shifts being applied to all diagonals in the same QB column.

The term "constellation block", or "modulation block", generally refers to a group of bits mapped to one or more complex symbols that are decoded jointly in the receiver.

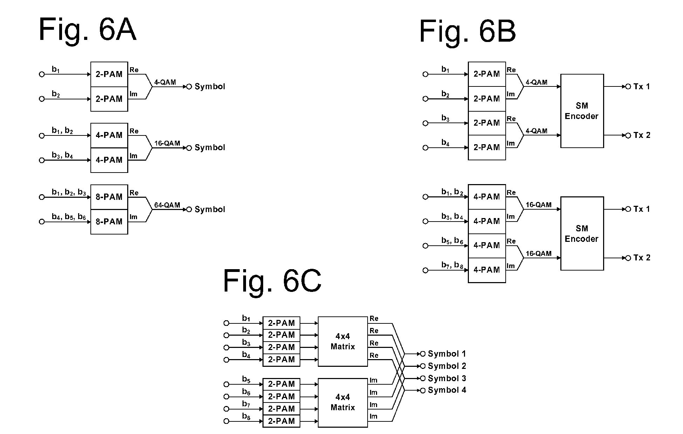

The most simple example is the QAM (quadrature amplitude modulation) constellation, which consists of one real and one imaginary component, the two components being modulated independently using PAM (pulse amplitude modulation), which is also referred to as ASK (amplitude shift keying). Figure 6A illustrates this for three common constellation sizes: 4-QAM, 16-QAM, and 64-QAM, encoding 2, 4, and 6 bits onto one complex symbol, respectively.

A further example of constellation blocks can be found in the case of SM (spatial-multiplexing) for MIMO (multiple-input multiple-output) communications, whereby a plurality of symbols are transmitted in parallel over a plurality of transmit antennas. In order to ensure optimal performance, the plurality of symbols must be decoded jointly in the receiver, thus forming a constellation block. Prior to being modulated and transmitted, the plurality of symbols can be encoded with an optional code for increased robustness.

Figure 6B shows two examples of MIMO spatial multiplexing with two transmit antennas, where two complex symbols are transmitted in parallel, for 4-QAM and 16-QAM constellations, respectively. The same principle can easily be extended to more than two antennas.

A further example of constellation blocks can be found in the case of rotated constellations. In order to increase the transmission robustness, a plurality of PAM-modulated real components are grouped into vectors and multiplied by an orthogonal square matrix. Subsequently, each real component is transmitted in a different complex symbol, so that the fading experienced over the channel is as uncorrelated as possible. Figure 6C illustrates this concept in the case of 4-QAM constellations with rotation in four dimensions. In order to ensure optimal performance, the four symbols must be decoded jointly, thus forming a constellation block.

Referring again to the definition of constellation blocks, a further aspect is that the parameter M is chosen to be a divisor of the number of bits in a constellation block. Typically M=B, where B is the number of bits per PAM symbol. Each constellation block therefore consists of one or more groups of M bits. In the following we denote the number of such groups by G. Thus, each constellation block consists of M*G bits, and there are Q/G constellation blocks per interleaver section. It is also assumed that G is a divisor of Q.

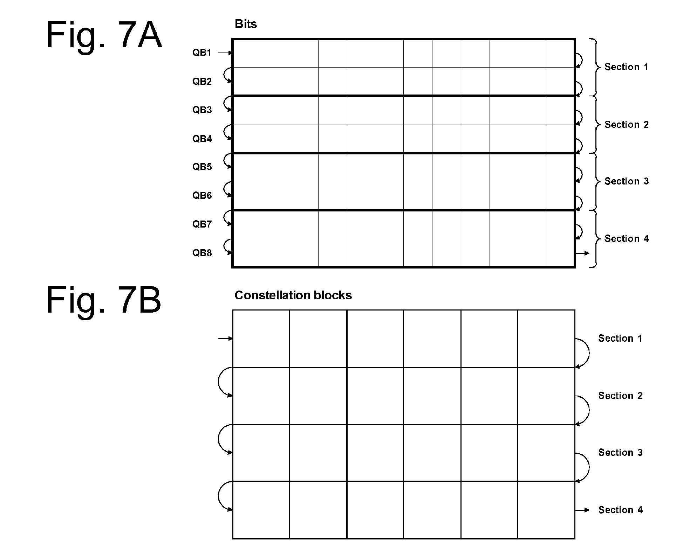

The output of the constellation mapper therefore consists of groups of Q/G constellation blocks, as shown in Figures 7A and 7B for Q=12, M=2, and G=2. In this example the resulting number of constellation blocks per section is Q/G=6. Figure 7A shows the bits of the LDPC block as they enter the bit interleaver, while Figure 7B shows the constellation blocks as they exit the constellation mapper.

If the constellation blocks were transmitted in their natural order, an error burst would affect only a limited number of QBs. In DVB-T2 for instance, there are 45 or 180 QBs per LDPC block. Since not all QBs have the same importance in the LDPC decoding process, the performance degradation depends on which QBs are affected, which in turn depends on the position of the error burst. This undesirable effect can be mitigated by permuting the order of the constellation blocks by means of a dedicated interleaver prior to the transmission. In the DVB-T2 standard this interleaver is referred to as cell interleaver since it is applied to complex cells.

The solution adopted in the DVB-T2 standard and subsequently in the DVB-NGH standard (ETSI EN 303 105) is to apply a pseudo-random permutation, so that error bursts are randomly spread over the LDPC block. In both DVB-T2 and DVB-NGH the permutation is generated using an LFSR (linear feedback shift register). Moreover, the permutation is different for each LDPC block for additional randomization.

While this approach is clearly better than using no cell interleaver, it is still not optimal as the effect of the error burst on the performance still depends on its position in the LDPC block. Moreover, these performance variations are not the same for all LDPC blocks since each block uses a different cell permutation.

### SUMMARY OF THE INVENTION

In view of the above conventional problems, it is the object of the present invention to improve the time diversity in a digital communication system that uses a quasi-cyclic low-density parity-check code, thereby increasing its resilience against error bursts.

This is achieved by the features as set forth in the independent claims.

Preferred embodiments are the subject matter of dependent claims.

It is the particular approach of the present invention to adapt the cell interleaver to the structure of the bit interleaver. Specifically, the cell interleaver is implemented in form of a column-row interleaver wherein the number of rows is equal to the number of bit interleaver sections or to a multiple thereof. In this manner, the time diversity of the system can be improved.

According to a first aspect of the present invention, a method for transmitting a codeword of a quasi-cyclic low-density parity-check code is provided, the codeword consisting of N cyclic blocks, each cyclic block consisting of Q bits. The method comprises the steps of applying a bit permutation to the bits of the codeword; dividing the permuted codeword into a sequence of constellation blocks, each constellation block consisting of G·M bits, G and M being positive integers; applying a constellation block permutation to the sequence of constellation blocks; and transmitting the permuted sequence of constellation blocks, and is characterized in that the codeword is divided into N/M sections, each section comprising M cyclic blocks, each constellation block being associated with a corresponding one of the sections; the bit permutation is adapted such that each constellation block is made up of G·M bits from M distinct cyclic blocks of the corresponding section; and the constellation block permutation is equivalent to writing the sequence of constellation blocks row-wise into a matrix with R rows and ((N·Q)/(G·M))/R columns and reading out the permuted constellation blocks column-wise, wherein R is equal to the number of sections N/M or a multiple thereof.

According to a second aspect of the present invention, an apparatus for transmitting a codeword of a quasi-cyclic low-density parity-check code is provided, the codeword consisting of N cyclic blocks, each cyclic block consisting of Q bits. The apparatus comprises a bit interleaver for applying a bit permutation to the bits of the codeword; a constellation mapper for dividing the permuted codeword into a sequence of constellation blocks, each constellation block consisting of G·M bits, G and M being positive integers; a cell interleaver for applying a constellation block permutation to the sequence of constellation blocks; and a modulator for transmitting the permuted sequence of constellation blocks, and is characterized in that the codeword is divided into N/M sections, each section comprising M cyclic blocks, each constellation block being associated with a corresponding one of the sections; the bit permutation is adapted such that each constellation block is made up of G·M bits from M distinct cyclic blocks of the corresponding section; and the constellation block permutation is equivalent to writing the sequence of constellation blocks row-wise into a matrix with R rows and ((N·Q)/(G·M))/R columns and reading out the permuted constellation blocks column-wise, wherein R is equal to the number of sections N/M or a multiple thereof.

Preferably, the step of applying the bit permutation is performed by applying a section permutation to the bits of each section independently of each other. In this manner, the process of performing the bit permutation can be parallelized.

Preferably, the section permutation is a column-row permutation, which is equivalent to writing the M.Q bits of each section row-wise into a matrix with Q columns and M rows and reading out the permuted bits column-wise. Such a permutation may be implemented in a particularly efficient manner.

According to a further aspect of the present invention, a method for receiving a codeword of a quasi-cyclic low-density parity-check code is provided, the codeword consisting of N cyclic blocks, each cyclic block consisting of Q bits. The method comprises the steps of receiving a permuted sequence of constellation blocks, each constellation block consisting of G·M bits, G and M being positive integers; applying an inverse constellation block permutation to the permuted sequence of constellation blocks; concatenating the sequence of constellation blocks to a permuted codeword; and applying an inverse bit permutation to the bits of the permuted codeword, and is characterized in that the inverse constellation block permutation and the inverse bit permutation are adapted for reverting the constellation block permutation and the bit permutation according to the first aspect of the present invention, respectively.

According to a further aspect of the present invention, an apparatus for receiving a codeword of a quasi-cyclic low-density parity-check code is provided, the codeword consisting of N cyclic blocks, each cyclic block consisting of Q bits. The apparatus comprises a demodulator for receiving a permuted sequence of constellation blocks, each constellation block consisting of G·M bits, G and M being positive integers; a cell deinterleaver for applying an inverse constellation block permutation to the permuted sequence of constellation blocks; a constellation demapper for concatenating the sequence of constellation blocks to a permuted codeword; and a bit deinterleaver for applying an inverse bit permutation to the bits of the permuted codeword, and is characterized in that the inverse constellation block permutation and the inverse bit permutation are adapted for reverting the constellation block permutation and the bit permutation according to the second aspect of the present invention, respectively.

The above and other objects and features of the present invention will become more apparent from the following description and preferred embodiments given in conjunction with the accompanying drawings, in which:
- Fig. 1: shows a block diagram of a transmitter employing LDPC codes and cell interleaving;
- Fig. 2: shows a parity-check matrix of an example quasi-cyclic LDPC code;
- Fig. 3: shows an example bit interleaver for quasi-cyclic LDPC codes;
- Fig. 4A: shows a schematic representation of row-column interleaving of each bit-interleaver section;
- Fig. 4A: shows another schematic representation of row-column interleaving of Fig. 4A;
- Fig. 5: shows an example bit interleaver with additional QB and intra-QB permutations;
- Fig. 6A: illustrates the generation of QAM symbols;
- Fig. 6B: illustrates examples of MIMO spatial multiplexing with two transmit antennas;
- Fig. 6C: illustrates an example of rotated constellations in four dimensions;
- Fig. 7A: illustrates the input of a conventional bit interleaver;
- Fig. 7B: illustrates the output of a conventional constellation mapper;

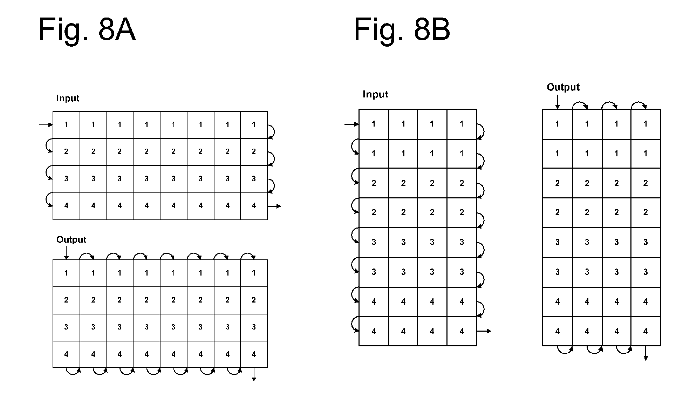

- Fig. 8A: illustrates optimal cell interleaving according to an embodiment of the present invention;
- Fig. 8B: illustrates optimal cell interleaving according to an alternative embodiment of the present invention; and

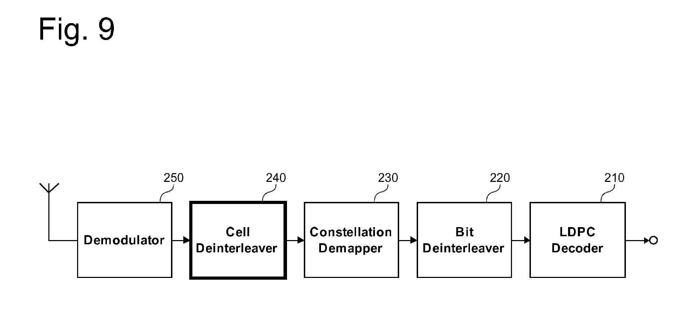

- Fig. 9: shows a block diagram of a receiver employing a cell deinterleaver and an LDPC decoder.

### DETAILED DESCRIPTION

The inventor has realized that the average system performance and the dependence thereof on the position of an error burst can be minimized by replacing the pseudo-random cell interleaver with a row-column interleaver that is adapted to the structure of the bit interleaver, and in particular to the number of sections *N*/*M*. The row-column interleaver may be identical for all LDPC blocks.

According to a preferred embodiment of the present invention, the cell interleaving is performed by writing the constellation blocks of each FEC block row-by-row into a matrix with *S* rows and *Q*/*G* columns and reading them out column-by-column, where *S*=*N*/*M* denotes the number of interleaver sections.

Figure 8A shows a non-limiting example of the interleaving process with *S=4* sections and Q/G=8 constellation blocks per section. The numbers in each square indicate the section to which the corresponding constellation block belongs. It can be easily seen that an error burst affects all sections (and therefore all QBs) evenly, regardless of its position in the LDPC block.

According to a more general embodiment of the present invention, the cell interleaving is performed by writing the constellation blocks of each FEC block row-by-row into a matrix with *R* rows and *((N*·*Q)*/*(G*·*M))*/*R* columns and reading them out column-by-column, wherein *R* is a multiple of the number of sections *S=N*/*M,* preferably *R*=*2S* or *R*=*4S.* In other words, the number of columns in the interleaver matrix is a divisor of the number of cells per section.

Figure 8B shows another non-limiting example of the interleaving process with *R*=*2S*, i.e., with 4 columns instead of 8 columns as in the example of Fig. 8A.

A transmitter according the present invention has the same structure as the generic transmitter depicted in Fig. 1 with the exception that cell interleaver 140 is a row-column interleaver rather than a pseudo-random permutation as defined in the DVB-T2 and the DVB-NGH standard.

The receiver mirrors the functionality of the transmitter. A block diagram is provided in Figure 9.

The signal from the receive antenna (or plurality of antennas) is first processed by a radio-frequency RF frontend (not shown), typically comprising a tuner and a down-converter, then by a demodulator 250, which produces constellation blocks at its output, each constellation block consisting of one or a plurality of complex symbols, as well as the associated channel fading coefficients.

The constellation blocks are deinterleaved in cell interleaver 240 using the inverse of the permutation disclosed in the present invention. Subsequently, a constellation demapper 230 extracts the bits encoded in the constellation block. How the bit extraction is performed is known in the art. The extracted bits are deinterleaved in bit interleaver 220 using the inverse of the bit permutation in the transmitter and passed to the LDPC decoder 210.

Summarizing, the present invention relates to digital communication systems that employ quasi-cyclic low-density parity-check (QC-LDPC) codes. A transmitter comprises a bit interleaver for permuting bits of a QC-LDPC codeword, a constellation mapper for mapping the permuted bits to constellation blocks, and a cell interleaver for permuting the constellation blocks. The bit interleaver can be implemented in a highly efficient manner if the codeword is divided into a plurality of sections such the bit permutation can be performed independently for each section. Moreover, a high degree of time diversity is achieved by implementing the cell interleaver in form of a column-row interleaver wherein the number of rows is equal to the number of bit interleaver sections or to a multiple thereof. The bit deinterleaver and the cell deinterleaver of a corresponding receiver are configured to revert the respective permutations in the transmitter.

## Claims

1. A method for transmitting a codeword of a quasi-cyclic low-density parity-check code, the codeword consisting of *N* cyclic blocks, each cyclic block consisting of *Q* bits, the method comprising the steps of
applying a bit permutation to the bits of the codeword;
dividing the permuted codeword into a sequence of constellation blocks, each constellation block consisting of *G*·*M* bits, *G* and *M* being positive integers;
applying a constellation block permutation to the sequence of constellation blocks; and
transmitting the permuted sequence of constellation blocks,
**characterized in that**
the codeword is divided into *N*/*M* sections, each section comprising *M* cyclic blocks, each constellation block being associated with a corresponding one of the sections;
the bit permutation is adapted such that each constellation block is made up of G·*M* bits from *M* distinct cyclic blocks of the corresponding section; and
the constellation block permutation is equivalent to writing the sequence of constellation blocks row-wise into a matrix with *R* rows and *((N*·*Q)*/*(G*·*M))*/*R* columns and reading out the permuted constellation blocks column-wise, wherein *R* is equal to the number of sections *N*/*M* or a multiple thereof.

2. A method according to claim 1, wherein the step of applying the bit permutation is performed by applying a section permutation to the bits of each section independently of each other.

3. A method according to claim 2, wherein the step of applying the section permutation is equivalent to writing the *M.Q* bits of each section row-wise into a matrix with *Q* columns and *M* rows and reading out the permuted bits column-wise.

4. A method for receiving a codeword of a quasi-cyclic low-density parity-check code, the codeword consisting of *N* cyclic blocks, each cyclic block consisting of *Q* bits, the method comprising the steps of
receiving a permuted sequence of constellation blocks, each constellation block consisting of *G*·*M* bits, *G* and *M* being positive integers;
applying an inverse constellation block permutation to the permuted sequence of constellation blocks;
concatenating the sequence of constellation blocks to a permuted codeword; and
applying an inverse bit permutation to the bits of the permuted codeword,
**characterized in that**
the inverse constellation block permutation and the inverse bit permutation are adapted for reverting the constellation block permutation and the bit permutation of claim 1, respectively.

5. An apparatus for transmitting a codeword of a quasi-cyclic low-density parity-check code, the codeword consisting of *N* cyclic blocks, each cyclic block consisting of *Q* bits, the apparatus comprising:
a bit interleaver (120) for applying a bit permutation to the bits of the codeword;
a constellation mapper (130) for dividing the permuted codeword into a sequence of constellation blocks, each constellation block consisting of *G*·*M* bits, *G* and *M* being positive integers;
a cell interleaver (140) for applying a constellation block permutation to the sequence of constellation blocks; and
a modulator (150) for transmitting the permuted sequence of constellation blocks,
**characterized in that**
the codeword is divided into *N*/*M* sections, each section comprising *M* cyclic blocks, each constellation block being associated with a corresponding one of the sections;
the bit permutation is adapted such that each constellation block is made up of G·*M* bits from *M* distinct cyclic blocks of the corresponding section; and
the constellation block permutation is equivalent to writing the sequence of constellation blocks row-wise into a matrix with *R* rows and *((N*·*Q)*/*(G*·*M))*/*R* columns and reading out the permuted constellation blocks column-wise, wherein *R* is equal to the number of sections *N*/*M* or a multiple thereof.

6. The apparatus of claim 5, wherein the bit interleaver (120) is configured to perform the bit permutation by applying a section permutation to the bits of each section independently of each other.

7. The apparatus of claim 6, wherein the bit interleaver (120) is configured to apply the section permutation by writing the *M.Q* bits of each section row-wise into a matrix with *Q* columns and *M* rows and reading out the permuted bits column-wise.

8. An apparatus for receiving a codeword of a quasi-cyclic low-density parity-check code, the codeword consisting of *N* cyclic blocks, each cyclic block consisting of *Q* bits, the apparatus comprising:
a demodulator (250) for receiving a permuted sequence of constellation blocks, each constellation block consisting of *G*·*M* bits, G and *M* being positive integers;
a cell deinterleaver (240) for applying an inverse constellation block permutation to the permuted sequence of constellation blocks;
a constellation demapper (230) for concatenating the sequence of constellation blocks to a permuted codeword; and
a bit deinterleaver (220) for applying an inverse bit permutation to the bits of the permuted codeword,
**characterized in that**
the inverse constellation block permutation and the inverse bit permutation are adapted for reverting the constellation block permutation and the bit permutation of claim 5, respectively.
